# EUROPÄISCHE PATENTSCHRIFT

(11) **EP 0 804 994 B1**
(45) Veröffentlichungstag und Bekanntmachung des Hinweises auf die Patenterteilung: **04.09.2002**
(21) Anmeldenummer: 97102219.9
(22) Anmeldetag: 12.02.1997
(51) Int. Cl.: B23K 20/00, H01L 21/60

(54) **Vorrichtung zum "Ball"-Bonden**
Apparatus for ball bonding
Dispositif de jonction par bille

(30) Priorität: 30.04.1996 DE 19617360; 07.05.1996 DE 19618320
(43) Veröffentlichungstag der Anmeldung: 05.11.1997
(73) Patentinhaber: F & K Delvotec Bondtechnik GmbH, 85521 Ottobrunn (DE)
(72) Erfinder: Farassat, Farhad, 82024 Taufkirchen (DE)
(74) Vertreter: Popp, Eugen, Dr.

(56) Entgegenhaltungen:
- EP-A- 0 494 510
- US-A- 4 575 602

## Beschreibung

Die Erfindung betrifft eine Vorrichtung gemäß dem Oberbegriff des Anspruchs 1 (EP-A- 494 510). Vorrichtungen zum "Ball"-Bonden mit einem Bond-Werkzeug (Wedge-Kapillare), durch die ein Bonddraht, insbesondere Aluminium-Draht, hindurchgeführt und die auf- bzw. von den Bondstellen zu- bzw. wegbewegbar ist, und mit einer Einrichtung zur Ausbildung eines "Balls" am freien Ende des Bonddrahtes vor Aufschweißen desselben auf eine zugeordnete Bondstelle, sind allgemein bekannt und z. B. in der EP-B-0 299 987 oder US-A-4 586 642 beschrieben. Beim Stand der Technik nach der EP-B-0 299 987 umfaßt die Einrichtung zur Ausbildung eines "Balls" am freien Ende des Bonddrahtes eine sogenannte Abflammlanze. Diese ist mittels eines Motors auf- und abbewegbar sowie mittels eines weiteren Motors auf die Bonddrahtspitze zu- bzw. von dieser wieder wegbewegbar. Beiden Motoren ist jeweils ein Zählwerk zugeordnet, die über eine Recheneinheit miteinander gekoppelt sind, so daß die gewünschte Zuordnung der Abflammlanze zur freien Drahtspitze selbsttätig bzw. vollautomatisch herstellbar ist.

Das in der US 4,575,602 beschriebene Gerät zur Bildung von Bond-"Bällen" treibt über einen gemeinsamen Antrieb mit einer Rotationsachse eine Auf- und Abwärtsbewegung eines Bondwerkzeuges, eine Auf- und Abwärtsbewegung eines Zylinders und eine horizontale Schwenkbewegung einer Einrichtung zur Ausbildung eines "Balls" an. Hierbei wird die Einrichtung zur Ausbildung eines "Balls", die eine Abflammlanze umfaßt, horizontal aus der Fallbewegungsrichtung des "Balls" herausgeschwenkt, sobald der "Ball" ausgebildet ist. Die flache Abflammlanze ist hierfür in einem relativ großen Abstand zu dem unteren Ende des Bondwerkzeuges und einer Einrichtung zur Erzeugung einer Inertgasatmosphäre angeordnet.

EP 0 494 510 A2 beschreibt einen Bondkopf, der nicht horizontal sondern vertikal verschwenkbar ist. Demzufolge ist ein großer Abstand zwischen dem unteren Ende des Bondwerkzeuges und dem Werkstück erforderlich, um so ausreichend Raum für die vertikale Verschwenkung des Bondkopfes zur Verfügung zu stellen.

Der vorliegenden Erfindung liegt die Aufgabe zugrunde, eine Vorrichtung zum "Ball"-Bonden der bekannten Art so fortzubilden, daß die Ausbildung des "Balls" und dessen freier Fall zu dem zu bondenden Werkstück weitestgehend ohne äußere Einflüsse in einer Inertgas-Umgebung erfolgt.

Diese Aufgabe wird erfindungsgemäß durch die Merkmale des Anspruches 1 gelöst. Gemäß der vorliegenden Erfindung umfaßt die Einrichtung zur Ausbildung eines "Balls" eine Abflammlanze, deren in Schwenkrichtung der Einrichtung ausgerichtete Querschnittsfläche L-förmig ist. Durch die Anordnung eines die L-Form bildenden vertikalen Schenkels wird sichergestellt, daß der auszubildende und freifallende "Ball" von einer Inertgasatmosphäre umgeben wird.

Die Einrichtung zur Ausbildung eines "Balls" ist mit dem Bond-Werkzeug bzw. einem dieses tragenden Bondkopf derart mechanisch gekoppelt, daß sie beim Absenken des Bond-Werkzeugs bzw. des zugeordneten Bondkopfes in eine Bondstellung aus ihrer "Ball"-Bildungs-Position herausschwenkbar ist. Damit wird sicher eine Kollision zwischen Abflamm-Einrichtung und Bondwerkzeug verhindert. Auf diese Weise wird ohne gesonderte Motoren oder dergleichen Antriebe erreicht, daß das Bond-Werkzeug ungehindert auf eine auch nahe einer Gehäuse- oder dergleichen Wandung angeordneten Bondstelle zubewegbar ist. Diese Bewegung wird durch die Einrichtung zur Ausbildung des "Balls" an der Bonddrahtspitze nicht behindert. Aufgrund der mechanischen Koppelung zwischen der vorgenannten Einrichtung und dem Bond-Werkzeug bzw. dem dieses tragenden Bondkopfs ist der Aufwand für das Herausbewegen der Einrichtung zur Ausbildung des "Balls" an der Bonddrahtspitze vergleichsweise minimal. Gesonderte Antriebe dafür sind nicht erforderlich. Die Schwenkbewegung der Einrichtungsausbildung des "Balls" bzw. der dieser Einrichtung zugeordneten Abflammlanze erfolgt zwangsgesteuert durch die Auf- und Abbewegung des Bondkopfes. Vorzugsweise erfolgt das Herausschwenken der Einrichtungsausbildung eines "Balls" bzw. der dieser Einrichtung zugeordneten Abflammlanze aus der "Ball"-Bildungs-Position entgegen der Wirkung eines elastischen Rückstellelements, insbesondere entgegen der Wirkung einer Torsionsfeder. Damit ist ein gesonderter Antrieb für eine Rückbewegung der vorgenannten Einrichtung in die "Ball"-Bildungs-Position entbehrlich. Diese Maßnahme fördert die Reduzierung des Gesamtaufwandes erheblich. Eine besonders einfache konstruktive Ausbildung der Erfindung besteht darin, daß am zusammen mit dem Bond-Werkzeug auf- bzw. abbewegbaren Bondkopf ein sich parallel zur Bewegungsrichtung erstreckender Steuerarm mit an einem Ende, insbesondere dem der Bondstelle zugewandten unteren Ende, ausgebildeter Steuerfläche angeordnet ist, die mit einem um eine sich ebenfalls parallel zur Bewegungsrichtung erstreckende Achse verschwenkbaren Haltearm zusammenwirkt, an dessen freiem Ende die Einrichtung zur Ausbildung eines "Balls" bzw. die Abflammlanze angeordnet ist. Mit vorgenannter Maßnahme wird die Auf- und Abbewegung des Bondkopfes in eine horizontale Schwenkbewegung des Haltearmes für die Abflammlanze umgesetzt.

Zur Einstellung des relativen Bewegungsablaufes ist der Steuerarm in Bewegungsrichtung bzw. in Richtung parallel zu seiner Längserstreckung verstellbar am Bondkopf angeordnet.

Weitere konstruktive Details, die die oben gestellte Aufgabe fördern, sind in den Ansprüchen 5 bis 7 beschrieben, auf die hier Bezug genommen wird.

Im übrigen wird hinsichtlich weiterer Merkmale auch auf die nachstehende Beschreibung einer bevorzugten Ausführungsform der Erfindung hingewiesen, die in den anliegenden Zeichnungen schematisch dargestellt ist. Diese zeigen in
- Fig. 1: eine erfindungsgemäß ausgebildete Bondvorrichtung in Vorderansicht;
- Fig. 2: die Bondvorrichtung gemäß Fig. 1 in Draufsicht;
- Fig. 3: die Abflammlanze in Zuordnung zum Bond-Werkzeug in Vertikalschnitt und vergrößertem Maßstab und
- Fig. 4: die Abflammlanze gemäß Fig. 3 im Schnitt längs Linie IV - IV in Fig. 3.

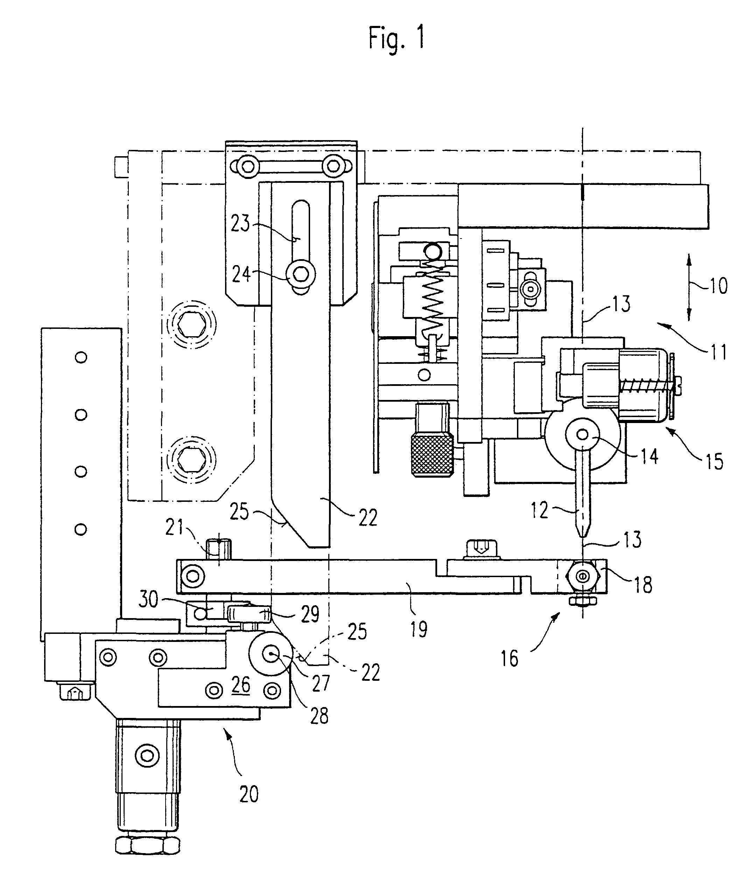

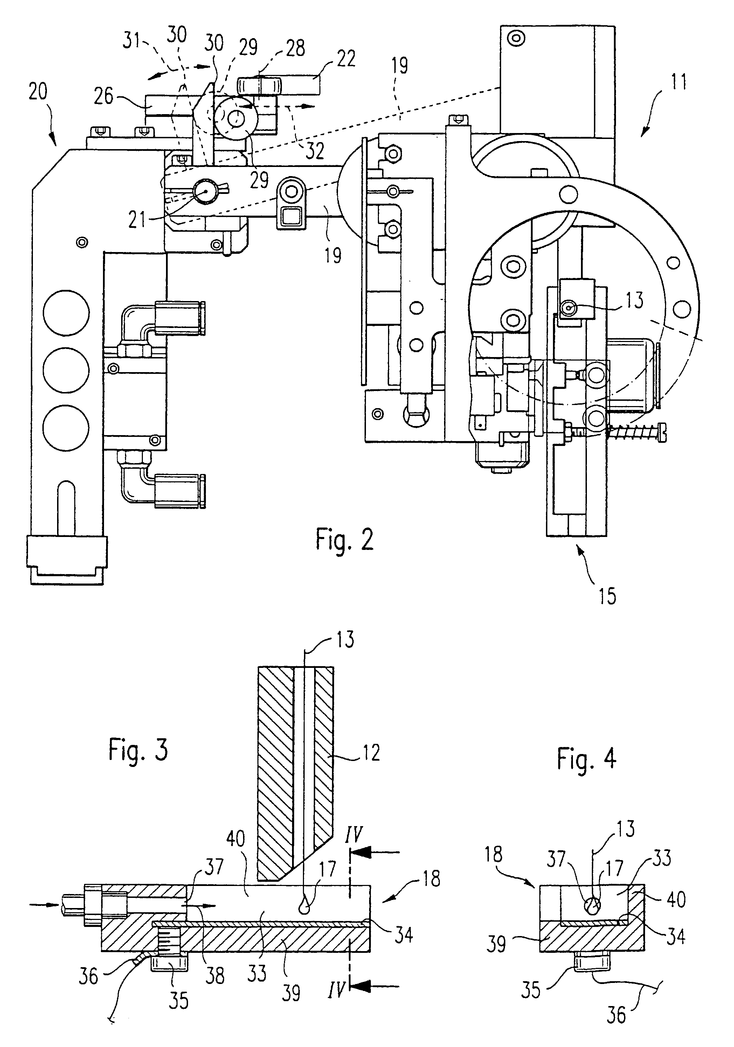

In den Fig. 1 und 2 ist ein in Richtung des Doppelpfeiles 10 auf- und abbewegbarer Bondkopf 11 in Vorder- und Draufsicht dargestellt. Dieser Bondkopf 11 umfaßt ein Bond-Werkzeug 12, das auch als "Wedge-Kapillare" bezeichnet wird. Durch dieses Bond-Werkzeug 12 erstreckt sich ein nicht näher dargestellter Bonddraht, insbesondere Aluminiumdraht 13 hindurch. Das Bond-Werkzeug 12 ist am freien Ende eines Ultraschallerregers bzw. "Transducers" 14 angeordnet. Dem Transducer ist in Bonddraht-Vorschubrichtung eine Draht-Abreißklammer 15 vorgeordnet. Da es sich bei den vorgenannten Bauteilen um allgemein bekannte Konstruktionselemente handelt, wird hier auf eine nähere Beschreibung derselben verzichtet.

Dem unteren freien Ende des nicht näher dargestellten Bonddrahtes 13 bzw. der Bonddrahtspitze ist eine Einrichtung 16 zur Ausbildung eines "Balls" 17 (siehe Fig. 3 und 4) am freien Ende des Bonddrahtes 13 zugeordnet. Die Ausbildung des "Balls" an der Bonddrahtspitze erfolgt unmittelbar vor Aufschweißen derselben auf eine zugeordnete und hier nicht näher dargestellte Bondstelle. Die erwähnte Einrichtung zur Ausbildung eines "Balls" umfaßt eine sogenannte Abflammlanze 18, die am freien Ende eines in horizontaler Ebene verschwenkbar gelagerten Haltearmes 19 befestigt ist. Der Haltearm 19 samt Abflammlanze 18 ist an einem gesonderten ortsfesten Maschinenteil 20 um eine sich parallel zur Bewegungsrichtung 10 des Bond-Werkzeugs 12 bzw. des Bondkopfes 11 erstreckende Achse 21 verschwenkbar gelagert. Am Bondkopf 11 ist ein sich ebenfalls parallel zur Bewegungsrichtung 10 desselben erstreckender Steuerarm 22 befestigt, und zwar in Richtung parallel zur Bewegungsrichtung 10 einstellbar. Zu diesem Zweck weist der Steuerarm 22 am Bondkopf-Befestigungsabschnitt ein Langloch 23 auf, durch das sich eine Befestigungsschraube 24 hindurcherstreckt. Das der Bondstelle zugekehrte untere Ende des Steuerarms 22 ist keilförmig ausgebildet unter Darstellung einer sich schräg zur Bewegungsrichtung 10 des Bondkopfes 11 erstreckenden Steuerfläche 25. Beim Absenken des Bondkopfes 11 unter entsprechender Mitnahme des Bond-Werkzeugs 12 kommt die Steuerfläche 25 des Steuerarms 22 mit einer Rolle 27 in Kontakt, die auf einem horizontal verschieblich gelagerten Schlitten 26 drehbar gelagert ist, wobei die Rollenachse sich senkrecht zur Bewegungsrichtung 10 des Bondkopfes sowie parallel zur Steuerfläche 25 des Steuerarms 22 erstreckt. Die Steuerfläche 25 drängt durch den erwähnten Kontakt mit der Rolle 27 den Schlitten 26 zur Seite, und zwar in den Fig. 1 und 2 nach links unter gleichzeitiger Mitnahme einer weiteren Rolle 29, die auf dem Schlitten 26 um eine Vertikalachse drehbar gelagert ist und an einem Mitnehmer 30 anliegt, der fest mit dem Haltearm 19 und dann mit diesem verschwenkbar verbunden ist. Durch die Rolle 29 und deren Kontakt mit dem Mitnehmer 30 wird beim Absenken des Bondkopfes 11 der Haltearm 19 sowie die damit verbundene Abflammlanze 18 aus der "Ball"-Bildungs-Position herausgeschwenkt, so wie dies in Fig. 2 durch die gestrichelte Lage des Haltearmes 19 dargestellt ist. In dieser Position des Haltearmes 19 und damit auch der Abflammlanze 18 kann der Bondkopf samt Bond-Werkzeug 12 ungehindert weiter nach unten abgesenkt werden, bis das Bond-Werkzeug 12 in Anlage an die zugeordnete Bondstelle gelangt unter Aufschweißen des "Balls" 17 an der Bondstelle. Zum Absenken des Bond-Werkzeugs 12 wird die Abflammlanze 19 nicht behindert mit der Folge, daß das Bond-Werkzeug 12 auch an Bondstellen heranbewegt werden kann, die nahe einer aufrechten Gehäusewand oder dergleichen liegt. Damit sind Bondstellen auch innerhalb eines topfförmigen Gehäuses zugänglich, selbst dann, wenn diese sich nahe der Gehäusewand befinden. Die beschriebene Zwangssteuerung zwischen Bondkopf 11 und Abflammlanze 18 bzw. deren Haltearm 19 ermöglicht eine besonders einfache Konstruktion. Die Rückbewegung des Haltearmes 19 samt Abflammlanze 18 erfolgt durch eine Torsionsfeder, die hier nicht näher dargestellt ist. Diese Torsionsfeder ist um die Schwenkachse 21 des Haltearmes 19 wirksam. Alternativ kann auch eine Schraubendruck- oder Schraubenzugfeder als Rückstellelement dienen.

Die Schwenkbewegung des Mitnehmers 30 bedingt durch die Hinund Herbewegung der Rolle 29 ist durch den Doppelpfeil 31 angedeutet. Dieser Schwenkbewegung folgt der Haltearm 19 gleichermaßen aufgrund der starren Verbindung zwischen Mitnehmer 30 und Haltearm 19, wobei sich der Mitnehmer 30 bei der dargestellten Ausführungsform senkrecht zum Haltearm 19 erstreckt, und zwar auf Höhe der Schwenkachse 21 des Haltearmes 19. Die erwähnte Hin- und Herbewegung der mit dem Mitnehmer 30 zusammenwirkenden Rolle 29 ist in Fig. 2 mit dem Doppelpfeil 32 angedeutet. Der Doppelpfeil 32 entspricht natürlich auch der Hin- und Herbewegung des Schlittens 26 bedingt durch die Auf- und Abbewegung des Steuerarms 22, der der Auf- und Abbewegung 10 des Bondkopfes 11 folgt.

In den Fig. 3 und 4 ist die Abflammlanze 18 in vergrößertem Maßstab in Längs- sowie Querschnitt dargestellt. Dementsprechend umfaßt die Abflammlanze einen im Querschnitt (Fig. 4) L-förmigen Abschnitt. In den durch die beiden Schenkel des L-förmigen Abschnitts begrenzten Raum 33 taucht zum Zwecke der Ausbildung eines "Balls" an der Bonddrahtspitze diese ein, so wie dies in den Fig. 3 und 4 dargestellt ist. An der Oberseite des Horizontalschenkels der Abflammlanze ist eine Flachelektrode 34 angeordnet, die über eine Klemm- und Kontaktschraube 35 mit einer elektrischen Leitung 36 verbunden ist. Die elektrische Leitung 36 führt zu einer nicht näher dargestellten Stromquelle. Die Klemm- und Kontaktschraube 35 dient auch zur Fixierung der Flachelektrode 34 an der Oberseite des Horizontalschenkels der Abflammlanze 18, so wie dies in Fig. 3 angedeutet ist.

Oberhalb der Flachelektrode 34 mündet stirnseitig in den durch die beiden Schenkel der Abflammlanze begrenzten Raum 33 eine Öffnung 37, durch die hindurch in den Raum 33 Inertgas, insbesondere Argon, eingeblasen wird (Pfeil 38).

Der Horizontalschenkel der Abflammlanze 18 ist in den Fig. 3 und 4 mit der Bezugsziffer 39 gekennzeichnet, während der Vertikalschenkel die Bezugsziffer 40 aufweist. An der dem Vertikalschenkel 40 gegenüberliegenden Seite ist die Abflammlanze 18 offen. Dementsprechend kann die Abflammlanze 18 ungehindert die anhand der Fig. 1 und 2 beschriebene Horizontal-Schwenkbewegung durchführen, ohne daß die Abflammlanze zu diesem Zweck vorher abgesenkt oder die Drahtspitze mit "Ball" 17 angehoben werden muß.

Die beschriebene Vorrichtung eignet sich insbesondere für das "Ball"-Bonden von Aluminium-Dickdraht. Dabei ist zu bedenken, daß man bisher ein "Ball"-Bonden mit Aluminiumdraht im normalen Fertigungsbetrieb nicht für möglich gehalten hat. Durch schnelle Oxidation der Drahtspitze bei der Ausbildung eines "Balls" neigt dieser zur Abtrennung, bevor er auf eine Bondstelle gepreßt werden kann. Die Drahtspitze brennt also regelrecht ab. Da erfindungsgemäß die Ausbildung des "Balls" 17 in einer Inertgas-Umgebung erfolgt, ist der Aluminiumdraht jedoch beherrschbar geworden. Dies gilt insbesondere für Aluminium-Dickdraht, aber natürlich auch für Aluminium-Dünndraht.

### Bezugszeichenliste

- 10: Doppelpfeil
- 11: Bondkopf
- 12: Bondkapillare (Wedge-Kapillare)
- 13: Bonddraht
- 14: Transducer
- 15: Abreißklammer
- 16: Einrichtung zur Ausbildung eines "balls"
- 17: "ball"
- 18: Abflammlanze
- 19: Haltearm
- 20: Maschinenteil
- 21: Schwenkachse
- 22: Steuerarm
- 23: Langloch
- 24: Befestigungsschraube
- 25: Steuerfläche
- 26: Schlitten
- 27: Rolle
- 28: Rollenachse
- 29: Rolle
- 30: Mitnehmer
- 31: Doppelpfeil
- 32: Doppelpfeil
- 33: Raum
- 34: Flachelektrode
- 35: Klemm- und Kontaktschraube
- 36: elektrische Leitung
- 37: Öffnung
- 38: Pfeil
- 39: Horizontalschenkel
- 40: Vertikalschenkel

## Patentansprüche

1. Vorrichtung zum "Ball"-Bonden mit eine Bond kappillare, insbesondere Wedge-Kappillare (12), durch das ein Bonddraht (13), insbesondere ein Aluminiumdraht, hindurchgeführt wird und das auf bzw. von Bondstellen zu- bzw. wegbewegbar ist, und mit einer Einrichtung (16) zur Ausbildung eines Balls (17) am freien Ende des Bonddrahtes (13) vor Aufschweißen desselben auf eine zugeordnete Bondstelle, wobei die Einrichtung (16) zur Ausbildung eines "Balls" (17) mit der Bondkapillare (12) bzw. einem diese tragenden Bondkopf (11) derart mechanisch gekoppelt ist, daß sie beim Absenken der Bondkappillare (12) bzw. des zugeordneten Bondkopfes (11) in eine Bondstellung aus ihrer "Ball"-Bildungs-Position in einer horizontalen Ebene herausschwenkbar ist,
**dadurch gekennzeichnet, daß**
die Einrichtung (16) zur Ausbildung eines "Balls" (17) eine Abflammlanze (18) umfaßt, deren in Schwenkrichtung der Einrichtung (16) ausgerichtete Querschnittsfläche L-förmig ist.

2. Vorrichtung nach Anspruch 1,
**dadurch gekennzeichnet, daß**
das Herausschwenken der Einrichtung (16) zur Ausbildung eines "Balls" (17) aus der "Ball"-Bildungs-Position entgegen der Wirkung eines elastischen Rückstellelements, insbesondere einer Torsionsfeder, erfolgt.

3. Vorrichtung nach Anspruch 1 oder 2,
**dadurch gekennzeichnet, daß**
am zusammen mit dem Bond Kappillare (12) auf- und abbewegbaren Bondkopf (11) ein sich parallel zur Bewegungsrichtung (10) erstreckender Steuerarm (22) mit an einem Ende, insbesondere dem der Bondstelle zugewandten unteren Ende, ausgebildeten Steuerfläche (25) angeordnet ist, die direkt oder indirekt mit einem um eine sich ebenfalls parallel zur Bewegungsrichtung (10) des Bondkopfes (11) erstreckende Achse (21) verschwenkbaren Haltearm (19) zusammenwirkt, an dessen freiem Ende die Einrichtung (16) zur Ausbildung eines "Balls" (17) angeordnet ist.

4. Vorrichtung zu Anspruch 3,
**dadurch gekennzeichnet, daß**
der Steuerarm (22) in Bewegungsrichtung (10) des Bondkopfes (11) bzw. in Richtung parallel zu seiner Längsterstreckung verstellbar ist.

5. Vorrichtung nach Anspruch 3 oder 4,
**dadurch gekennzeichnet, daß**
die Steuerfläche (25) des Steuerarms (22) mit einem quer zu dessen Längserstreckung verschieblich gelagerten Schlitten (26) zusammenwirkt, welcher bei Verschiebung aus einer Ausgangsposition heraus die Schwenkbewegung des Haltearms (19) für die Einrichtung (16) zur Ausbildung eines "Balls" (17) veranlaßt.

6. Vorrichtung nach einem der Ansprüche 1 bis 5,
**dadurchgekennzeichnet, daß**
die Abflammlanze (18) eine mit einer Stromquelle verbindbare Elektrode (34) aufweist.

7. Vorrichtung nach Anspruch 6,
**dadurch gekennzeichnet, daß**
in dem Bereich zwischen den beiden Schenkeln (39, 40) der Abflammlanze (18) eine Öffnung (37) zur Einleitung von Inertgas, insbesondere Argon, mündet.

## Claims

1. A ball bonding device including a bonding capillary, in particular a wedge capillary (12), through which a bonding wire (13), in particular an aluminum wire, is passed, and which can be moved towards and/or away from bonding pads, and including a means (16) for forming a ball (17) on the free end of the bonding wire (13) prior to welding same onto an associated bonding pad, said means (16) for forming a ball (17) including said bonding capillary (12) and a bonding head (11), respectively, carrying same being mechanically coupled in such a manner that upon lowering the bonding capillary (12) and the associated bonding head (11), respectively, into a bonding position, it can be pivoted out from its ball formation position in a horizontal plane,
**characterized in that**
said means (16) for forming a ball (17) comprises a flame-off lance (18), the cross-sectional surface thereof oriented into the pivot direction of said means (16) being L-shaped.

2. The device according to claim 1,
**characterized in that**
pivoting said means (16) for forming a ball (17) out of the ball formation position ensues against the action of an elastic pull-back element, in particular a torsion spring.

3. The device according to claim 1 or 2,
**characterized in that**
on said bonding head (11) which can be raised or lowered in conjunction with the bonding capillary, a control arm (22) is arranged extending in parallel to the movement direction (10) including a control surface (25) formed on one end, in particular on the lower end facing the bond pad, which control surface (25) cooperates directly or indirectly with a holding arm (19) likewise pivotable about an axis (21) extending in parallel to the movement direction (10) of the bonding head (11), on the free end of which holding arm (19) said means (16) for forming a ball (17) is arranged.

4. The device according to claim 3,
**characterized in that**
said control arm (22) is adjustable in the movement direction (10) of the bonding head (11) and/or in the direction in parallel to the maximal extension thereof.

5. The device according to claim 3 or 4,
**characterized in that**
the control surface (25) of said control arm (22) cooperates with a slide (26) mounted displaceable transversely to the longitudinal extension thereof, which slide (26), upon displacement out of an initial position, causes the pivot movement of the holding arm (19) for the means (16) for forming a ball (17).

6. The device according to any one of claims 1 through 5,
**characterized in that**
said flame-off lance (18) has an electrode (34) which can be connected to a current source.

7. The device according to claim 6,
**characterized in that**
an opening (37) leads into the zone between the two legs (39, 40) of the flame-off lance for feeling in inert gas, in particular argon.

## Revendications

1. Appareil pour réaliser des connexions en "boule" avec un capillaire de connexion, en particulier un capillaire de coin (12), dans lequel passe un fil de connexion (13), en particulier un fil de connexion en aluminium, qui peut être approché ou écarté de points de connexion, et avec un dispositif (16) pour former une boule (17) à l'extrémité libre du fil de connexion (13) avant la soudure de celui-ci en un point de connexion affecté, dans lequel le dispositif (16) pour former une "boule" (17) avec le capillaire de coin (12), respectivement une tête de connexion (11) qui le porte est couplé mécaniquement de manière telle que lors de l'abaissement du capillaire de coin (12), respectivement de la tête de connexion (11) affectée, il puisse sortir par pivotement dans un plan horizontal de sa position de formation de boule en une position de connexion,
**caractérisé en ce que**
le dispositif (16) pour former une "boule" (17) comprend une lance de flambage (18), dont la surface de section orientée vers la direction de pivotement du dispositif (16) est en forme de L.

2. Appareil selon la revendication 1,
**caractérisé en ce que** la sortie par pivotement du dispositif (16) pour former une "boule" (17) de la position de formation de "boule" s'effectue contre l'effet d'un élément élastique de repositionnement, en particulier d'un ressort de torsion.

3. Appareil selon la revendication 1 ou 2,
**caractérisé en ce que**, à la tête de connexion (11) qu'il est possible d'approcher et écarter conjointement avec le capillaire de connexion (12), un bras de guidage (22) est disposé s'étendant parallèlement à la direction du mouvement (10) avec à une extrémité, en particulier l'extrémité inférieure dirigée vers le point de connexion, des surfaces de guidage (25) formées qui, directement ou indirectement, agit conjointement avec un bras support (19) pivotant autour d'un axe (21) s'étendant également parallèlement à la direction du mouvement (10) de la tête de connexion (11), à l'extrémité libre duquel le dispositif (16) pour former une "boule" (17) est disposé.

4. Appareil selon la revendication 3,
**caractérisé en ce que** le bras de guidage (22) est décalable dans la direction du mouvement (10) de la tête de connexion (11), respectivement dans la direction parallèle à son allongement maximal.

5. Appareil selon la revendication 3 ou 4,
**caractérisé en ce que** la surface de guidage (25) du bras de guidage (22) agit conjointement avec un traîneau positionné de manière translatable en travers de son allongement longitudinal, qui, lors d'une translation hors d'une position d'origine déclenche le mouvement de pivotement du bras support (19) pour le dispositif (16) pour former une "boule" (17).

6. Appareil selon l'une des revendications 1 à 5,
**caractérisé en ce que** la lance de flambage (18) présente une électrode (34) raccordable à une source de courant.

7. Appareil selon la revendication 6,
**caractérisé en ce que** dans la zone entre les deux montants (39, 40) de la lance de flambage (18) débouche une ouverture (37) pour apporter du gaz inerte, en particulier de l'argon.
